# FASCICULE DE BREVET EUROPEEN

(11) **EP 1 993 771 B1**
(45) Date de publication et mention de la délivrance du brevet: **30.04.2014**
(21) Numéro de dépôt: 07717795.4
(22) Date de dépôt: 09.01.2007
(51) Int. Cl.: B23K 1/19, B23K 1/005

(54) **PROCEDE DE BRASAGE ENTRE EUX D'AU MOINS DEUX ORGANES EMPILES**
VERFAHREN ZUM ZUSAMMENSCHWEISSEN VON MINDESTENS ZWEI STAPELTEILEN
METHOD OF WELDING TOGETHER AT LEAST TWO STACKED MEMBERS

(30) Priorité: 10.01.2006 FR 0600205
(43) Date de publication de la demande: 26.11.2008
(73) Titulaire: Valeo Etudes Electroniques, 94042 Créteil Cédex (FR)
(72) Inventeur: MARTIN, Gérard-Marie, F-75008 Paris (FR); MORELLE, Jean-Michel, F-45190 Beaugency (FR); VIVET, Laurent, F-78390 Bois-d'arcy (FR)
(74) Mandataire: de la Bigne, Guillaume Michel Marie
(86) Numéro de dépôt international: PCT/FR2007/050632
(87) Numéro de publication internationale: WO 2007/080350

(56) Documents cités:
- DE-A1- 10 015 938
- FR-A- 2 802 764
- BRANDNER M ET AL: "SOLDERING WITH SOLID STATE AND DIODE LASERS: ENERGY COUPLING, TEMPERATURE RISE, PROCESS WINDOW" JOURNAL OF LASER APPLICATIONS, XX, XX, vol. 12, no. 5, octobre 2000 (2000-10), pages 194-199, XP009072628 ISSN: 1042-346X

## Description

La présente invention concerne un procédé de brasage entre eux d'au moins trois éléments empilés, un procédé de réalisation d'un modèle mathématique pour la mise en oeuvre du procédé de brasage et un module électronique.

Elle s'applique plus particulièrement au brasage d'un module électronique comprenant un premier élément formant support, par exemple un circuit imprimé, sur lequel sont empilés au moins des deuxième et troisième éléments formant organes électriques, les trois éléments étant brasés entre eux.

L'empilement des organes électroniques sur le support permet d'obtenir un module électronique relativement compact.

On connaît déjà dans l'état de la technique un procédé de brasage entre eux d'au moins deux éléments empilés formant une pile, du type dans lequel on dirige un laser sur une face d'extrémité de la pile de façon à ce que le laser chauffe la pile et on règle au moins un paramètre du laser.

Habituellement, le paramètre du laser est un paramètre choisi parmi une durée d'irradiation, une surface d'irradiation de la face d'extrémité de la pile par le laser et une puissance d'irradiation du laser.

La pile comprend par exemple un support formant circuit imprimé (premier élément de la pile) et une pastille semi-conductrice (deuxième élément de la pile). Entre ces deux éléments est intercalée une masse formant brasure.

La pile est caractérisée par certaines particularités thermiques, notamment la température critique de la pastille semi-conductrice au-delà de laquelle la pastille est détruite et la température de fusion de la brasure qui doit être inférieure à la température critique de la pastille semi-conductrice.

En général, on règle chaque paramètre du laser de façon empirique à une valeur telle que, d'une part, la température maximale atteinte de la pile n'excède pas la température critique de la pastille semi-conductrice et, d'autre part, que la température maximale atteinte de la pile soit supérieure à la température de fusion de la masse formant brasure.

Ainsi, dans le cas d'une pile comprenant seulement deux éléments, le réglage de la valeur de chaque paramètre du laser peut être réalisé empiriquement du fait que le nombre de caractéristiques thermiques de la pile à prendre en compte est limité.

Or, le nombre de caractéristiques thermiques dont il faut tenir compte augmente avec le nombre d'éléments de la pile.

Par conséquent, lorsque la pile comprend au moins trois éléments, un réglage empirique de la valeur du paramètre est trop aléatoire pour tenir compte de l'ensemble des caractéristiques thermiques de la pile et peut conduire à une brasure de qualité relativement médiocre entre deux éléments de la pile voire à un endommagement d'un des éléments de la pile.

L'invention a pour but de proposer un procédé de brasage entre eux d'au moins deux éléments empilés dans lequel le réglage de la valeur du paramètre du laser est relativement rapide et précis, ceci quel que soit le nombre d'éléments de la pile.

A cet effet, l'invention a pour objet un procédé de brasage selon la revendication 1.

Ainsi, de façon avantageuse, il est possible de déterminer rapidement et précisément la valeur du paramètre du laser grâce au modèle mathématique.

Le modèle mathématique peut être implémenté sous la forme d'un programme d'ordinateur fournissant une valeur de réglage du paramètre laser précise et adaptée, contrairement aux procédés empiriques classiques.

Le procédé de brasage selon l'invention peut en outre comporter les caractéristiques :
- le paramètre du laser est un paramètre choisi parmi une durée d'irradiation, une surface d'irradiation de la face d'extrémité de la pile par le laser et une puissance d'irradiation du laser ;
- la caractéristique thermique de la pile est choisie parmi une température critique d'endommagement d'un élément de la pile, une température de fusion d'une masse formant brasure intercalée entre deux éléments de la pile et une température d'un matériau synthétique bordant un des éléments de la pile.

L'invention a encore pour objet un procédé de réalisation d'un modèle mathématique pour la mise en oeuvre du procédé de brasage selon l'invention défini à la revendication 3.

Un procédé de réalisation d'un modèle mathématique selon l'invention peut en outre comporter les caractéristiques suivantes :
- le modèle mathématique comprend au moins une fonction mathématique de type polynomiale ;
- la zone s'étend sur une deuxième face d'extrémité de l'échantillon et les températures remarquables sont des températures maximales relevées dans une sous-zone remarquable de cette zone ;
- la sous-zone remarquable sépare une partie de la zone destinée à être recouverte d'une masse formant brasure d'une autre partie de la zone destinée à ne pas être recouverte de la masse formant brasure ;
- la sous-zone est la projection sur la deuxième face d'extrémité de l'échantillon de la surface d'irradiation du laser ;
- un élément de l'échantillon comprenant une partie métallique bordée par une partie en matériau synthétique, la sous-zone remarquable sépare la partie métallique de la partie en matériau synthétique ;
- préalablement à l'étape de relevé des températures, on noircit la zone de l'échantillon ;
- les températures sont relevées à partir d'un traitement d'une image infrarouge de la zone de l'échantillon ;
- le plan expérimental est un plan du type choisi parmi un plan Box Behnken, un plan central composite et un plan D-optimal ;
- le modèle mathématique est déterminé à partir d'une méthode d'analyse de la variance des températures remarquables.

L'invention sera mieux comprise à la lecture de la description qui va suivre, donnée uniquement à titre d'exemple et faite en se référant aux dessins dans lesquels :
- la figure 1 est une vue schématique d'un module électronique ;
- les figures 2 à 4 sont des vues schématiques d'échantillons du module électronique de la figure 1 à différentes étapes d'un procédé de réalisation d'un modèle mathématique pour la mise en oeuvre d'un procédé de brasage selon l'invention.

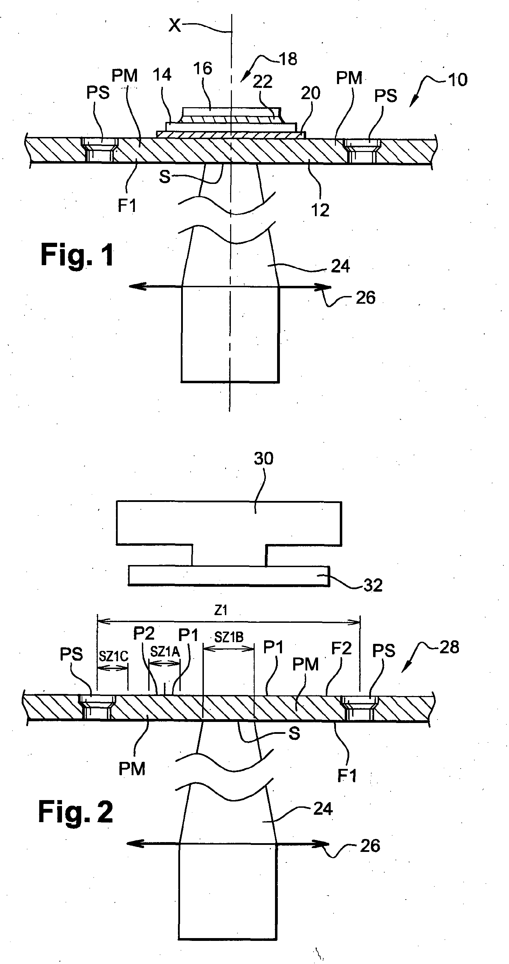

On a représenté sur la figure 1 un module électronique. Ce module électronique est désigné par la référence générale 10.

Le module électronique 10 comprend un premier élément 12. Dans l'exemple décrit, le premier élément 12 forme un support.

Dans l'exemple illustré, le support 12 comporte une partie PM métallique bordée partiellement par une partie PS en matériau synthétique (plastique). Le support 12 peut être, de façon avantageuse un substrat de circuit imprimé.

En variante, le support 12 peut être réalisé dans un matériau céramique.

Le module électronique 10 comprend également des deuxième 14 et troisième 16 éléments empilés selon un axe vertical X sur la partie métallique PM du support 12 de manière à ce que les trois éléments 12, 14 et 16 forment une pile 18.

Les deuxième et troisième éléments 14 et 16 forment par exemple des organes électroniques de type pastille semi-conductrice.

Les éléments de la pile 18 sont brasés entre eux conformément à un procédé de brasage selon l'invention par irradiation du module électronique 10 par un laser 24.

Ainsi, dans l'exemple illustré, des première 20 et deuxième 22 masses formant brasure sont intercalées respectivement entre le support 12 et la pastille 14 et entre la pastille 14 et la pastille 16.

De façon classique, les masses formant brasure 20 et 22 sont des masses de pâte ou des masses découpées dans un ruban et rapportées entre les éléments 12 à 16 de la pile 18 avant leur brasage.

En variante, les masses formant brasure peuvent être formées par des revêtements des pastilles 14 et 16, solidaires de ces pastilles avant leur brasage, le matériau des revêtements pouvant être dans ce cas de l'argent, de l'or, de l'étain, etc.

La chaleur, permettant de faire fondre les masses formant brasure 20 et 22 et ainsi de braser entre eux les trois éléments, est créée par l'irradiation du module électronique 10 par un laser 24 émis par une source laser (non représentée).

La source laser peut comporter, par exemple, une diode laser émettant un faisceau laser, notamment du type à infrarouge.

Le laser 24 est dirigé sur une face d'extrémité F1 de la pile 18 de façon à chauffer la pile 18. Plus particulièrement, le laser 24 est focalisé par des moyens 26 de focalisation du laser 24 sur une surface S d'irradiation de la partie métallique PM du support 12 par le laser 24.

Afin de chauffer suffisamment la pile 18 pour faire fondre les masses de brasure 20 et 22 sans endommager aucun des trois éléments de la pile 18, le laser 24 est muni de moyens de réglage (non représentés) d'une valeur d'au moins un paramètre du laser 24.

Dans l'exemple décrit, les paramètres du laser 24 sont une durée d'irradiation D, la surface d'irradiation S par le laser 24 de la face d'extrémité F1 et une puissance d'irradiation P du laser 24.

Les valeurs des paramètres D, S, P du laser 24 sont réglées de sorte à tenir compte de caractéristiques thermiques de la pile 18, notamment des températures de fusion des masses de brasure 20 et 22, des températures critiques des trois éléments de la pile 18 (lorsqu'un élément est chauffé au delà de sa température critique, il est détruit), ainsi que de la température de fusion du matériau synthétique bordant le support 12.

Par exemple, la température de fusion des masses formant brasure est de l'ordre de 300°C et les températures critiques des trois éléments de la pile 18 sont de l'ordre de 500°C.

Conformément au procédé de brasage de l'invention, on règle chaque paramètre du laser 24 à une valeur qui est l'image par un modèle mathématique M d'au moins une caractéristique thermique de la pile 18.

On décrira ci-dessous un procédé de réalisation du modèle mathématique M selon l'invention, en référence aux figures 2 à 4.

Afin de réaliser le modèle mathématique M, on suit les étapes suivantes, conformes à un plan expérimental.

De façon connue en soi, un plan expérimental permet de définir un nombre N d'expériences à réaliser pour obtenir un modèle mathématique suffisamment précis, ainsi que de définir pour chaque expérience, les valeurs des paramètres à régler.

Par exemple, le plan expérimental est un plan du type choisi parmi un plan Box Behnken, un plan central composite et un plan D-optimal. D'autres plans expérimentaux classiques peuvent être utilisés.

Ainsi, dans l'exemple décrit, le plan expérimental définit un ensemble E de valeurs de paramètres du laser 24 comprenant :
- un nombre N_{D} de valeurs Dᵢ de durée d'irradiation D du laser comprises entre une valeur minimale Dₘᵢₙ et une valeur maximale Dₘₐₓ, par exemple entre 200 ms et 700 ms,
- un nombre N_{P} de valeurs Pᵢ de puissance d'irradiation P comprises entre une valeur minimale Pₘᵢₙ et une valeur maximale Pₘₐₓ, par exemple entre 700W et 2000W,
- un nombre N_{S} de valeurs Sᵢ de surface d'irradiation S comprises entre une valeur minimale Sₘᵢₙ et une valeur maximale Sₘₐₓ.

Ainsi, le plan expérimental définit le nombre N d'expériences à réaliser, ces N expériences étant choisies, par exemple, parmi les combinaisons possibles des différentes valeurs des paramètres du laser, par exemple N= N_{D} x N_{P} x N_{S} dans le cas d'un plan expérimental dit « complet » ou N < N_{D} x N_{P} x N_{S} dans le cas d'un plan expérimental dit « fractionnaire », notamment du type Box Behnken, central composite ou D-optimal.

De ce fait, pour chaque expérience du plan expérimental, on règle les paramètres D, S, P du laser respectivement à des valeurs Dᵢ, Sᵢ, Pᵢ comprises dans l'ensemble E défini par le plan expérimental.

Dans un premier temps, on forme un premier échantillon 28 d'une partie de la pile 18 (figure 2). On voit sur la figure 2, que le premier échantillon 28 comprend uniquement le premier élément de la pile 18, à savoir le support 12.

Le premier échantillon 28 comprend une première face F1 d'extrémité correspondant à la face inférieure du support 12 et une deuxième face F2 d'extrémité correspondant à la face supérieure du support 12.

On réalise alors les N expériences définies par le plan expérimental sur ce premier échantillon 28.

Pour chaque expérience, on règle les paramètres D, S, P du laser 24 respectivement à des valeurs Dᵢ, Sᵢ, Pᵢ de l'ensemble E. On définit alors un vecteur « paramètre » VPᵢ ayant pour première, deuxième et troisième coordonnées respectivement les valeurs Dᵢ, Sᵢ et Pᵢ des trois paramètres D, S, P du laser 24.

On dirige le laser 24 sur la première face d'extrémité F1 pendant une durée d'irradiation D (réglée à la valeur Dᵢ) de cette face F1 par le laser 24 de façon à ce que le laser 24 chauffe le premier échantillon 28.

Au cours d'une, première étape, on relève alors des températures sur une zone Z1 du premier échantillon 28.

Dans l'exemple illustré, la zone Z1 s'étend sur la deuxième face d'extrémité F2 opposée à la première face F1 d'extrémité du premier échantillon 28.

De préférence, les températures sont relevées à partir d'un traitement d'une image infrarouge de la zone Z1 de l'échantillon 28.

L'image infrarouge est obtenue par des moyens classiques d'acquisition d'une image infrarouge comprenant, par exemple, une caméra infrarouge 30.

La caméra 30 est, par exemple, munie d'un objectif 32 avec un grand angle de champ adapté à la dimension de la zone Z1 et avec un grandissement suffisant pour obtenir une bonne résolution des éléments pertinents de la zone Z1.

Par ailleurs, la caméra 30 permet, par exemple, une acquisition des images à une fréquence de l'ordre de 50 Hz. Ainsi, pour une durée d'irradiation D du premier échantillon 28 par le laser 24 d'une valeur Dᵢ = 500 ms, il est possible d'obtenir 25 images de la zone Z1.

De préférence, avant de relever les températures sur la zone Z1 du premier échantillon 28, on noircit la zone Z1 (par exemple en la recouvrant d'un revêtement noir (peinture, etc)) de manière à former un « corps noir ».

Au cours d'une seconde étape, on sélectionne des températures remarquables parmi les températures relevées.

De préférence, les températures remarquables sont trois températures maximales relevées respectivement dans trois sous-zones remarquables SZ1A, SZ1B, SZ1C de la zone Z1 du premier échantillon 28.

En effet, la répartition des températures n'est pas uniforme dans le premier échantillon 28 et les températures sont plus élevées à proximité de la surface S d'irradiation de la pile 18 par le laser 24.

La première sous-zone SZ1A remarquable sépare une partie P1 de la zone Z1 destinée à être recouverte de la masse de brasure 20 d'une autre partie P2 de la zone Z1 destinée à ne pas être recouverte de la masse de brasure 20.

La deuxième sous-zone SZ1 B remarquable est la projection sur la deuxième face d'extrémité F2 du premier échantillon 28 de la surface S d'irradiation du laser.

La troisième sous-zone SZ1C remarquable sépare la partie métallique PM de la partie en matériau synthétique PS.

Pour chaque expérience, on définit trois premières coordonnées d'un vecteur « température » VTᵢ comme étant les trois températures maximales respectivement des sous-zones SZ1A, SZ1B, SZ1C correspondant au réglage des paramètres du laser aux valeurs Dᵢ, Sᵢ et Pᵢ du vecteur « paramètre » VPᵢ.

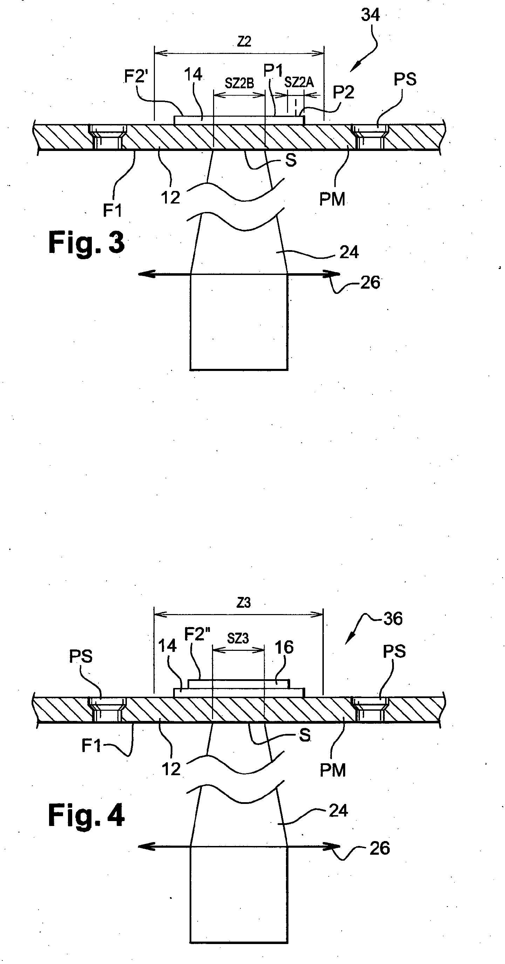

Dans un deuxième temps, on forme un deuxième échantillon 34 d'une partie de la pile 18 (figure 3). On voit sur la figure 3, que le deuxième échantillon 34 comprend uniquement les deux premiers éléments de la pile 18, à savoir le support 12 et la pastille 14.

Dans le deuxième échantillon 34, la seconde face F2' d'extrémité correspond à la face supérieure de la pastille 14.

De façon analogue au premier échantillon 28, on réalise les N expériences définies par le plan expérimental sur ce deuxième échantillon 34.

Ainsi, pour chaque expérience, on règle les paramètres D, S, P, du laser 24 aux valeurs Dᵢ, Sᵢ, Pᵢ de l'ensemble E et on définit un vecteur "paramètre" VPᵢ ayant pour première, deuxième et troisième coordonnées respectivement les valeurs Dᵢ, Sᵢ, Pᵢ des trois paramètres D, S, P du laser.

Au cours d'une première étape, on relève des températures sur une zone Z2 du deuxième échantillon 34 pendant une durée d'irradiation D de la première face F1 du deuxième échantillon 34 par le laser 24.

La zone Z2 s'étend sur la deuxième face F2' d'extrémité du deuxième échantillon 34.

De préférence, avant de relever les températures sur la zone Z2 du deuxième échantillon 34, on noircit la zone Z2 de manière à former un « corps noir ».

Ensuite, au cours d'une seconde étape, on sélectionne des températures remarquables parmi les températures relevées dans la zone Z2.

De préférence, les températures remarquables sont deux températures maximales relevées respectivement dans deux sous-zones remarquables SZ2A, SZ2B de la zone Z2.

La première sous-zone SZ2A remarquable sépare une partie P1 de la zone Z2 destinée à être recouverte de la masse de brasure 22 d'une autre partie P2 de la zone Z2 destinée à ne pas être recouverte de la masse de brasure 22.

La seconde sous-zone SZ2B remarquable est la projection sur la deuxième face d'extrémité F2' du deuxième échantillon 34 de la surface S d'irradiation du laser.

Pour chaque expérience, on définit des quatrième et cinquième coordonnées du vecteur « température » VTᵢ comme étant les températures maximales respectivement des sous-zones SZ2A et SZ2B correspondant au réglage des paramètres du laser aux valeurs Dᵢ, Sᵢ et Pᵢ du vecteur « paramètre » VPᵢ.

Dans un troisième temps, de façon optionnelle, on forme un troisième échantillon 36 d'une partie de la pile 18 (figure 4). On voit sur la figure 4, que le troisième échantillon 36 comprend les trois éléments de la pile 18, à savoir le support 12 et les deux pastilles semi-conductrices 14 et 16.

Dans le troisième échantillon 36, la deuxième face F2" d'extrémité correspond à la face supérieure de la pastille 16.

De façon analogue aux premier 28 et deuxième 34 échantillons, on réalise les N expériences définies par le plan expérimental sur ce troisième échantillon 36.

Ainsi, pour chaque expérience, on règle les paramètres D, S, P du laser 24 aux valeurs Dᵢ, Sᵢ, Pᵢ de l'ensemble E et on définit un vecteur « paramètre » VPᵢ ayant pour première, deuxième et troisième coordonnées respectivement les valeurs Dᵢ, Sᵢ et Pᵢ des trois paramètres D, S, P du laser.

Au cours d'une première étape, on relève des températures sur une zone Z3 du troisième échantillon 36 pendant une durée d'irradiation D de la première face F1 du troisième échantillon 36 par le laser 24.

De préférence, avant de relever les températures sur la zone Z3 du troisième échantillon 36, on noircit la zone Z3 de manière à former un « corps noir ».

Au cours d'une seconde étape, on sélectionne une température remarquable parmi les températures relevées dans la zone Z3. De préférence, la température remarquable est une température maximale relevée dans une sixième sous-zone remarquable SZ3 qui est la projection sur la deuxième face d'extrémité F2" du troisième échantillon 36 de la surface S d'irradiation du laser.

Pour chaque expérience, on définit une sixième coordonnée du vecteur « température » VTᵢ comme étant la sixième coordonnée la température maximale sélectionnée dans la sixième sous zone SZ6, correspondant à un réglage des paramètres du laser aux valeurs Dᵢ, Sᵢ et Pᵢ du vecteur « paramètre » VPᵢ.

Une fois que les N expériences ont été réalisées sur chacun des trois échantillons 28, 34 et 36, on obtient N vecteurs « paramètre » VPᵢ et N vecteurs « température » VTᵢ correspondants.

On définit alors le modèle mathématique M de manière à ce que chaque vecteur « paramètre » VPᵢ du laser 24 soit l'image par le modèle M de chaque vecteur « température » VTᵢ correspondant.

Dans cet exemple, le modèle mathématique M est défini à partir d'une méthode d'analyse de la variance des températures remarquables et comprend de préférence au moins une fonction mathématique de type polynomiale.

Ainsi, pour braser entre eux les trois éléments 12, 14, 16 de la pile 18, on procède de la façon suivante.

On définit un vecteur « température » VTᵢ ayant dans l'exemple décrit les première à sixième coordonnées suivantes:
- une température supérieure ou égale à la température de fusion de la masse de brasure 20,
- une température strictement inférieure à la température critique du support 12,
- une température strictement inférieure à la température de fusion du matériau synthétique bordant la partie métallique PM du support 12,
- une température supérieure ou égale à la température de fusion de masse de brasure 22,
- une température strictement inférieure à la température critique de la pastille 14, et
- une température strictement inférieure à la température critique de la pastille 16.

Puis on saisit les coordonnées de ce vecteur VTᵢ dans un ordinateur dans lequel est implémenté le modèle mathématique M de façon à obtenir au moins une image par ce modèle mathématique M de ce vecteur « température » VTᵢ (le vecteur VTᵢ peut éventuellement avoir plusieurs images par le modèle mathématique M). Cette image est un vecteur « paramètre » VPᵢ ayant pour coordonnées les valeurs Dᵢ, Sᵢ, Pᵢ adaptées au brasage de la pile 18.

Enfin, on règle les paramètres D, S, P du laser 24 aux valeurs Dᵢ, Sᵢ, Pᵢ, ce qui permet d'obtenir en une seule opération de brasage le module électronique 10 illustré sur la figure 1.

Le module électronique 10, obtenu par brasage laser, se distingue d'un module électronique obtenu par un procédé de brasage classique (four de refusions, etc.) par l'aspect des masses formant brasures.

En effet, le brasage laser provoque un échauffement intense et relativement court suivi d'un refroidissement relativement rapide. Ainsi, le matériau dans lequel sont réalisées les masses de brasure, se solidifie en formant de fines dendrites.

## Revendications

1. Procédé de brasage entre eux d'au moins trois éléments (12, 14, 16) empilés formant une pile (18), dans lequel on dirige un laser (24) sur une face d'extrémité de la pile de façon à ce que le laser (24) chauffe la pile (18) et on règle au moins un paramètre du lasser (24), **caractérisé en ce** la pile comporte un support (12), une première et une deuxième pastilles (14, 16) et une première et une deuxième masses (20, 22) formant brasure, chacune des masses (20, 22) étant intercalée entre deux des trois éléments (12, 14, 16), et en ce que l'on règle le paramètre à une valeur qui est l'image par un modèle mathématique de caractéristiques thermiques de la pile (18) incluant :
- la température critique de chacun des trois éléments (12, 14, 16) ;
- la température de fusion de chacune des masses (20, 22) formant brasure ;
- la température de fusion d'un matériau synthétique bordant un des trois éléments (12, 14, 16) de la pile (18) ;
et en ce que l'on définit un vecteur « température » VTi ayant les première à sixième coordonnées suivantes:
- une température supérieure ou égale à la température de fusion de la première masse de brasure 20 ;
- une température strictement inférieure à la température critique du support 12;
- une température strictement inférieure à la température de fusion du matériau synthétique bordant une partie métallique PM du support 12 ;
- une température supérieure ou égale à la température de fusion de la deuxième masse de brasure 22 ;
- une température strictement inférieure à la température critique de la première pastille 14 ;
- une température strictement inférieure à la température critique de la deuxième pastille 16 ;
le vecteur « température » ayant pour image un vecteur « paramètre » Vpi ayant pour coordonnées le ou les paramètres du laser (24).

2. Procédé de brasage selon la revendication 1, dans lequel le paramètre du laser est un paramètre choisi parmi une durée d'irradiation, une surface d'irradiation de la face d'extrémité de la pile (18) par le laser (24) et une puissance d'irradiation du laser (24).

3. Procédé de réalisation d'un modèle mathématique pour la mise en oeuvre du procédé de brasage selon l'une quelconque des revendications 1 ou 2, **caractérisé en ce qu**'il comprend les étapes suivantes, conformes à un plan expérimental :
- on dirige un laser (24) sur une face d'extrémité d'une pile de façon à ce que le laser (24) chauffe la pile (18) la pile comportant un support (12), une première et une deuxième pastilles (14, 16) et une première et une deuxième masses (20, 22) formant brasure, chacune des masses (20, 22) étant intercalée entre deux des trois éléments (12, 14, 16)
- de réglage de la valeur du paramètre du laser (24),
- de relevé des températures sur une zone (Z1, Z2, Z3) d'au moins un échantillon (28, 34, 36) d'au moins une partie de la pile (18) pendant une durée d'irradiation d'une première face d'extrémité (F1) de l'échantillon (28, 34, 36) par le laser,
- de sélection d'au moins une température remarquable parmi les températures relevées,
**et en ce qu**'il comprend également une étape de définition du modèle mathématique de manière à ce qu'un vecteur ayant au moins pour coordonnée la valeur du paramètre du laser soit l'image par le modèle mathématique d'un vecteur ayant au moins pour coordonnée la température remarquable, le modèle mathématique de caractéristiques thermiques de la pile (18) incluant :
- la température critique de chacun des trois éléments (12, 14, 16) ;
- la température de fusion de chacune des masses (20, 22) formant brasure ;
- la température de fusion d'un matériau synthétique bordant un des trois éléments (12, 14, 16) de la pile (18) ;
et en ce que l'on définit un vecteur « température » VTi ayant les première à sixième coordonnées suivantes:
- une température supérieure ou égale à la température de fusion de la première masse de brasure 20 ;
- une température strictement inférieure à la température critique du support 12;
- une température strictement inférieure à la température de fusion du matériau synthétique bordant une partie métallique PM du support 12 ;
- une température supérieure ou égale à la température de fusion de la deuxième masse de brasure 22 ;
- une température strictement inférieure à la température critique de la première pastille 14 ;
- une température strictement inférieure à la température critique de la deuxième pastille 16 ;
le vecteur « température » ayant pour image un vecteur « paramètre » Vpi ayant pour coordonnées le ou les paramètres du laser (24).

4. Procédé de réalisation d'un modèle mathématique selon la revendication 3, dans lequel le modèle mathématique comprend au moins une fonction mathématique de type polynomiale.

5. Procédé de réalisation d'un modèle mathématique selon la revendication 3 ou 4, dans lequel la zone (Z1, Z2, Z3) s'étend sur une deuxième face d'extrémité (F2, F2', F2") de l'échantillon (28, 34, 36) et les températures remarquables sont des températures maximales relevées dans une sous-zone (SZ1A, SZ1B, SZ1C, SZ2A, SZ2B, SZ3) remarquable de cette zone.

6. Procédé de brasage selon la revendication 5, dans lequel la sous-zone remarquable (SZ1A, SZ2A) sépare une partie (P1) de la zone (Z1, Z2) destinée à être recouverte d'une masse formant brasure d'une autre partie (P2) de la zone (Z1, Z2) destinée à ne pas être recouverte de la masse formant brasure.

7. Procédé de réalisation d'un modèle mathématique selon la revendication 5 ou 6, dans lequel la sous-zone est la projection (SZ1B, SZ2B, SZ3) sur la deuxième face (F2, F2', F2") d'extrémité de l'échantillon (28, 34, 36) de la surface (S) d'irradiation du laser.

8. Procédé de réalisation d'un modèle mathématique selon l'une quelconque des revendications 5 à 7, dans lequel, un élément (12) de l'échantillon (28) comprenant une partie métallique (PM) bordée par une partie en matériau synthétique (PS), la sous-zone remarquable (SZ1C) sépare la partie métallique (PM) de la partie en matériau synthétique (PS).

9. Procédé de réalisation d'un modèle mathématique selon l'une quelconque des revendications 3 à 8, dans lequel, préalablement à l'étape de relevé des températures, on noircit la zone (Z1, Z2, Z3) de l'échantillon (28, 34, 36).

10. Procédé de réalisation d'un modèle mathématique selon l'une quelconque des revendications 3 à 9, dans lequel les températures sont relevées à partir d'un traitement d'une image infrarouge de la zone (Z1, Z2, Z3) de l'échantillon (28, 34, 36).

11. Procédé de réalisation d'un modèle mathématique selon l'une quelconque des revendications 3 à 10, dans lequel le plan expérimental est un plan du type choisi parmi un plan Box Behnken, un plan central composite et un plan D-optimal.

12. Procédé de réalisation d'un modèle mathématique selon l'une quelconque des revendications 3 à 11, dans lequel le modèle mathématique est déterminé à partir d'une méthode d'analyse de la variance des températures remarquables.

## Patentansprüche

1. Verfahren zum Zusammenschweißen mindestens dreier gestapelter Elemente (12, 14, 16), die eine Zelle (18) bilden, bei dem ein Laser (24) auf eine Endfläche der Zelle gerichtet wird, so dass der Laser (24) die Zelle (18) erhitzt, und mindestens ein Parameter des Lasers (24) eingestellt wird, **dadurch gekennzeichnet, dass** die Zelle einen Träger (12), eine erste und eine zweite Pastille (14, 16) und eine erste und eine zweite Masse (20, 22), die ein Schweißmittel bilden, umfasst, wobei jede der Massen (20, 22) zwischen zwei der drei Elemente (12, 14, 16) angeordnet ist, und dass der Parameter auf einen Wert eingestellt wird, der durch ein mathematisches Modell das Abbild von thermischen Eigenschaften der Zelle (18) ist, umfassend:
- die kritische Temperatur jedes der drei Elemente (12, 14, 16);
- die Schmelztemperatur jeder der Massen (20, 22), die Schweißmittel bilden;
- die Schmelztemperatur eines synthetischen Materials, das an eines der drei Elemente (12, 14, 16) der Zelle (18) angrenzt;
und dass ein "Temperatur" vektor VTi mit den folgenden ersten bis sechsten Koordinaten definiert wird:
- einer Temperatur größer oder gleich der Schmelztemperatur der ersten Schweißmasse (20);
- einer Temperatur unbedingt unter der kritischen Temperatur des Trägers (12);
- einer Temperatur unbedingt unter der Schmelztemperatur des synthetischen Materials, das an einen metallischen Teil PM des Trägers (12) angrenzt;
- einer Temperatur größer oder gleich der Schmelztemperatur der zweiten Schweißmasse (22);
- einer Temperatur unbedingt unter der kritischen Temperatur der ersten Pastille (14);
- einer Temperatur unbedingt unter der kritischen Temperatur der zweiten Pastille (16);
wobei der "Temperatur" vektor als Abbild einen "Parameter" vektor Vpi mit dem oder den Laserparametern (24) als Koordinaten hat.

2. Schweißverfahren nach Anspruch 1, bei dem der Parameter des Lasers ein Parameter ist, der unter einer Bestrahlungsdauer, einer Bestrahlungsoberfläche der Endfläche der Zelle (18) durch den Laser (24) und einer Bestrahlungskraft des Lasers (24) ausgewählt ist.

3. Verfahren zur Erstellung eines mathematischen Modells für den Einsatz des Schweißverfahrens nach einem der Ansprüche 1 oder 2, **dadurch gekennzeichnet, dass** es die folgenden Schritte gemäß einem experimentellen Plan umfasst:
- Richten eines Lasers (24) auf eine Endfläche einer Zelle, so dass der Laser (24) die Zelle (18) erhitzt, wobei die Zelle einen Träger (12), eine erste und eine zweite Pastille (14, 16) und eine erste und eine zweite Masse (20, 22), die ein Schweißmittel bilden, umfasst, wobei jede der Massen (20, 22) zwischen zwei der drei Elemente (12, 14, 16) angeordnet ist,
- Einstellen des Werts des Parameters des Lasers (24),
- Feststellen der Temperaturen in einer Zone (Z1, Z2, Z3) mindestens eines Musters (28, 34, 36) mindestens eines Teils der Zelle (18) während einer Bestrahlungsdauer einer ersten Endfläche (F1) des Musters (28, 34, 36) durch den Laser,
- Auswahl mindestens einer bemerkenswerten Temperatur unter den festgestellten Temperaturen,
und dass es auch einen Schritt der Definition des mathematischen Modells umfasst, so dass ein Vektor, der mindestens den Wert des Parameters des Lasers als Koordinate hat, das Abbild eines Vektors durch das mathematische Modell ist, der als Koordinate mindestens die bemerkenswerte Temperatur hat, wobei das mathematische Modell von thermischen Eigenschaften der Zelle (18) einschließt:
- die kritische Temperatur jedes der drei Elemente (12, 14, 16);
- die Schmelztemperatur jeder der Massen (20, 22), die Schweißmittel bilden;
- die Schmelztemperatur eines synthetischen Materials, das an eines der drei Elemente (12, 14, 16) der Zelle (18) angrenzt;
und dass ein "Temperatur" vektor VTi mit den folgenden ersten bis sechsten Koordinaten definiert wird:
- einer Temperatur größer oder gleich der Schmelztemperatur der ersten Schweißmasse (20);
- einer Temperatur unbedingt unter der kritischen Temperatur des Trägers (12);
- einer Temperatur unbedingt unter der Schmelztemperatur des synthetischen Materials, das an einen metallischen Teil PM des Trägers (12) angrenzt;
- einer Temperatur größer oder gleich der Schmelztemperatur der zweiten Schweißmasse (22);
- einer Temperatur unbedingt unter der kritischen Temperatur der ersten Pastille (14);
- einer Temperatur unbedingt unter der kritischen Temperatur der zweiten Pastille (16);
wobei der "Temperatur" vektor als Abbild einen "Parameter" vektor Vpi mit dem oder den Laserparametern (24) als Koordinaten hat.

4. Verfahren zur Erstellung eines mathematischen Modells nach Anspruch 3, bei dem das mathematische Modell mindestens eine mathematische Funktion polynominalen Typs umfasst.

5. Verfahren zur Erstellung eines mathematischen Modells nach Anspruch 3 oder 4, bei dem sich die Zone (Z1, Z2, Z3) auf einer zweiten Endfläche (F2, F2', F2'') des Musters (28, 34, 36) erstreckt, und die bemerkenswerten Temperaturen Maximaltemperaturen sind, die in einer bemerkenswerten Unterzone (SZ1A, SZ1B, SZ1C, SZ2A, SZ2B, SZ3) dieser Zone festgestellt wurden.

6. Schweißverfahren nach Anspruch 5, bei dem die bemerkenswerte Unterzone (SZ1A, SZ2A) einen Teil (P1) von der Zone (Z1, Z2) trennt, der dazu bestimmt ist, mit einer Masse bedeckt zu werden, die ein Schweißmittel eines anderen Teils (P2) der Zone (Z1, Z2) bildet, der dazu bestimmt ist, nicht mit der ein Schweißmittel bildenden Masse bedeckt zu werden.

7. Verfahren zur Erstellung eines mathematischen Modells nach Anspruch 5 oder 6, bei dem die Unterzone die Projektion (SZ1B, SZ2B, SZ3) der Bestrahlungsfläche (S) des Lasers auf die zweite Endfläche (F2, F2', F2'') des Musters (28, 34, 36) ist.

8. Verfahren zur Erstellung eines mathematischen Modells nach einem der Ansprüche 5 bis 7, bei dem ein Element (12) des Musters (28) einen metallischen Teil (PM), der von einem Teil aus synthetischem Material (PS) umrandet ist, umfasst, die bemerkenswerte Unterzone (SZ1C) den metallischen Teil (PM) von dem Teil aus synthetischem Material (PS) trennt.

9. Verfahren zur Erstellung eines mathematischen Modells nach einem der Ansprüche 3 bis 8, bei dem vor dem Schritt der Feststellung der Temperaturen die Zone (Z1, Z2, Z3) des Musters (28, 34, 36) geschwärzt wird.

10. Verfahren zur Erstellung eines mathematischen Modells nach einem der Ansprüche 3 bis 9, bei dem die Temperaturen aus der Bearbeitung eines Infrarotbildes der Zone (Z1, Z2, Z3) des Musters (28, 34, 36) festgestellt werden.

11. Verfahren zur Erstellung eines mathematischen Modells nach einem der Ansprüche 3 bis 10, bei dem der experimentelle Plan ein Plan von dem Typ ist, der unter einem Box Behnken-Plan, einem zentralen Verbundplan und einem D-optimalen Plan ausgewählt ist.

12. Verfahren zur Erstellung eines mathematischen Modells nach einem der Ansprüche 3 bis 11, bei dem das mathematische Modell aus einer Methode zur Analyse der Varianz der bemerkenswerten Temperaturen bestimmt wird.

## Claims

1. Method of brazing together at least three stacked elements (12, 14, 16) forming a stack (18), in which a laser (24) is directed onto a end face of the stack so that the laser (24) heats the stack (18) and at least one parameter of the laser (24) is set, **characterized in that** the stack comprises a support (12), a first and a second pad (14, 16) and a first and a second braze-forming mass (20, 22), each of the masses (20, 22) being inserted between two of the three elements (12, 14, 16), and **in that** the parameter is set to a value which is the image through a mathematical model of thermal characteristics of the stack (18) including:
- the critical temperature of each of the three elements (12, 14, 16);
- the melting point of each of the braze-forming masses (20, 22);
- the melting point of a synthetic material edging one of the three elements (12, 14, 16) of the stack (18);
and **in that** a "temperature" vector VTi is defined that has the first to sixth following coordinates:
- a temperature greater than or equal to the melting point of the first braze mass (20);
- a temperature strictly lower than the critical temperature of the support (12);
- a temperature strictly lower than the melting point of the synthetic material edging a metal part PM of the support (12);
- a temperature greater than or equal to the melting point of the second braze mass (22);
- a temperature strictly lower than the critical temperature of the first pad (14);
- a temperature greater than the critical temperature of the second pad (16);
the "temperature" vector having for image a "parameter" vector Vpi having for coordinates the parameter or parameters of the laser (24).

2. Brazing method according to Claim 1, in which the parameter of the laser is a parameter chosen from an irradiation time, an area of irradiation of the end face of the stack (18) by the laser (24) and an irradiation power of the laser (24).

3. Method for producing a mathematical model for the implementation of the brazing method according to any one of Claims 1 or 2, **characterized in that** it comprises the following steps, in accordance with an experimental plan:
- a laser (24) is directed onto an end face of a stack so that the laser (24) heats the stack (18), the stack comprising a support (12), a first and a second pad (14, 16) and a first and a second braze-forming mass (20, 22), each of the masses (20, 22) being inserted between two of the three elements (12, 14, 16)
- the value of parameter of the laser (24) is set
- temperatures are recorded on an area (Z1, Z2, Z3) of at least one sample (28, 34, 36) of at least a part of the stack (18) during a time of irradiation of a first end face (F1) of the sample (28, 34, 36) by the laser,
- at least one temperature is selected that is noteworthy among the temperatures recorded,
**and in that it** also comprises a step of defining the mathematical model in such a way that a vector having at least for its coordinate the value of the parameter of the laser or the image by the mathematical model of a vector having at least for its coordinate the noteworthy temperature,
the mathematical model of thermal characteristics of the stack (18) including:
- the critical temperature of each of the three elements (12, 14, 16);
- the melting point of each of the braze-forming masses (20, 22);
- the melting point of a synthetic material edging one of the three elements (12, 14, 16) of the stack (18);
and **in that** a "temperature" vector VTi is defined that has the first to sixth following coordinates:
- a temperature greater than or equal to the melting point of the first braze mass (20);
- a temperature strictly lower than the critical temperature of the support (12);
- a temperature strictly lower than the melting point of the synthetic material edging a metallic part PM of the support (12);
- a temperature greater than or equal to the melting point of the second brazed mass (22);
- a temperature strictly lower than the critical temperature of the first pad (14);
- a temperature strictly lower than the critical temperature of the second pad (16);
the "temperature" vector having for image a "parameter" vector Vpi having for its coordinates the parameter or parameters of the laser (24).

4. Method for producing a mathematical model according to Claim 3, in which the mathematical model comprises at least one mathematical function of polynomial type.

5. Method for producing a mathematical model according to Claim 3 or 4, in which the area (Z1, Z2, Z3) extends over a second end face (F2, F2', F2") of the sample (28, 34, 36) and the noteworthy temperatures are maximum temperatures recorded in a noteworthy subarea (SZ1A, SZ1B, S2IC, SZ2A, SZ2B, SZ3) of this area.

6. Brazing method according to Claim 5, in which the noteworthy subarea (SZ1A, SZ2A) separates a part (P1) of the area (Z1, Z2) intended to be covered with a braze-forming mass from another part (P2) of the area (Z1, Z2) intended not to be covered by the braze-forming mass.

7. Method for producing a mathematical model according to Claim 5 or 6, in which the subarea is the projection (SZ1B, SZ2B, SZ3) onto the second end face (F2, F2', F2") of the sample (28, 34, 36) of the area (S) of irradiation of the laser.

8. Method for producing a mathematical model according to any one of Claims 5 to 7, in which, an element (12) of the sample (28) comprising a metallic part (PM) edged by a part made of synthetic material (PS), the noteworthy subarea (SZ1C) separates the metallic part (PM) from the part made of synthetic material (PS).

9. Method for producing a mathematical model according to any one of Claims 3 to 8, in which prior to the step of recording temperatures, the area (Z1, Z2, Z3) of the sample (28, 34, 36) is blackened.

10. Method for producing a mathematical model according to any one of Claims 3 to 9, in which the temperatures are recorded from a processing of an infrared image of the area (Z1, Z2, Z3) of the sample (28, 34, 36).

11. Method for producing a mathematical model according to any one of Claims 3 to 10, in which the experimental plan is a plan of the type chosen from a Box Behnken plan, a composite central plan and a D-optimal plan.

12. Method for producing a mathematical model according to any one of Claim 3 to 11, in which the mathematical model is determined from a method for analyzing the variance of the noteworthy temperatures.
